Europäisches Patentamt

European Patent Office

Office européen des brevets

(11) Publication number: **0 489 512 A2**

# EUROPEAN PATENT APPLICATION

(21) Application number: **91310581.3**

(22) Date of filing: **15.11.91**

(51) Int. Cl.5: **H02M 7/538**

(30) Priority: **05.12.90 GB 9026504**

(43) Date of publication of application:
**10.06.92 Bulletin 92/24**

(84) Designated Contracting States:
**BE DE DK ES FR GR IT LU NL SE**

(71) Applicant: **GPT LIMITED**
**New Century Park P.O. Box 53**
**Coventry, CV3 1HJ(GB)**

(72) Inventor: **Barson, Michael**
**32 Granby Road**
**Nuneaton CV10 8EH(GB)**

(74) Representative: **Branfield, Henry Anthony**
**The General Electric Company plc Patent**
**Department(Wembley Office) Hirst Research**
**Centre East Lane**
**Wembley, Middlesex HA9 7PP(GB)**

(54) Telephone ringer circuit.

(57) A ringer for a telephone system comprising a transformer having a first feedback loop controlling in use the primary current of the transformer in response to the ringer output and a second feedback loop controlling in use the secondary current of the transformer in response to the ringer output.

Fig.3.

The present invention relates to a ringer for use in a telephone network. The purpose of a ringer is to provide ring current to indicate to a telephone subscriber that there is an incoming call.

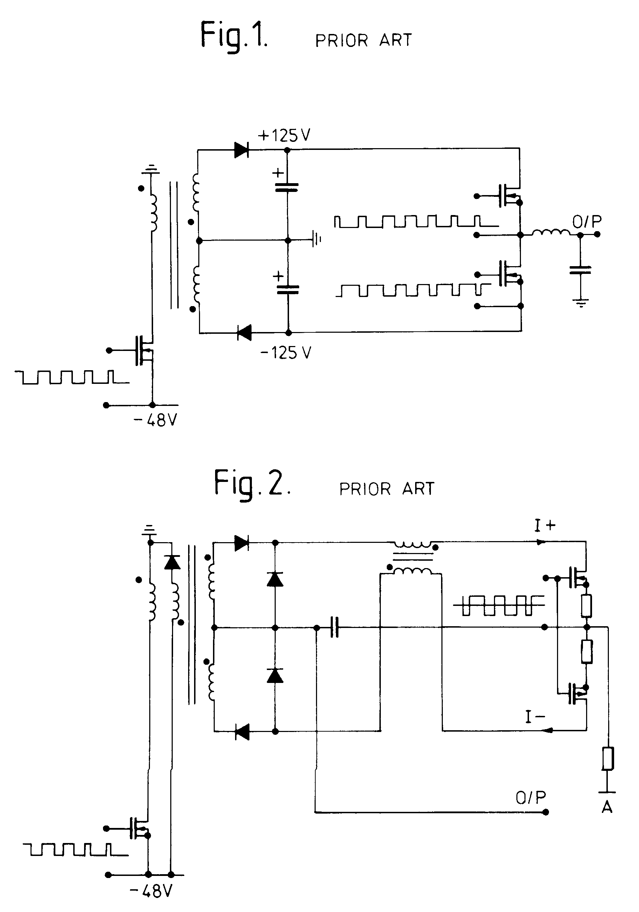

The ringer provides a low frequency sinusoidal waveform and prior art systems have used primary and secondary high frequency switching stages, such as are shown in Figures 1 and 2.

In the arrangement shown in Figure 1, a primary stage provides a pair of intermediate voltage rails. The secondary stage is pulse width modulated and swings between the two rails. The resulting modulated voltage waveform is then filtered to produce the required output waveform. Two high frequency switching stages are required which reduce the efficiency and cause high dissipation at maximum load and bulky filtering components are needed.

In Figure 2 the primary stage provides a current source to the secondary stage, which uses high frequency modulation techniques to form the required output voltage. The output current and secondary current are compared and used to limit the primary current, reducing excessive power dissipation. Again there is the disadvantage of requiring two high frequency switching stages and excessive currents circulate the output stage on full load.

According to the present invention there is provided a ringer for a telephone system comprising a transformer having a first feedback loop controlling in use the primary current of the transformer in response to the ringer output and a second feedback loop controlling in use the secondary current of the transformer in response to the ringer output.

One embodiment of the present invention will now be described, by way of example, with reference to the accompanying drawings, in which:-

Figures 1 and 2 as referred to earlier are circuit diagrams showing prior art ringers;

Figure 3 is a ringer circuit diagram showing the topology used in the embodiment; and

Figure 4 shows a ringer including the control loops using the topology of Figure 3.

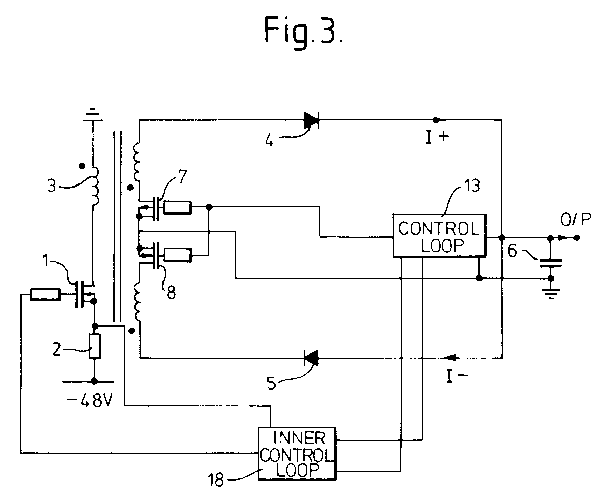

Figure 3 shows a fly back convertor being used to provide current sources I+ and I- controlled by a secondary switching stage, comprising a pair of MOSFETs 7 and 8. The output waveform is controlled by two voltage feedback loops 13,18, giving the circuit two modes of operation. When sufficient ringing current Iac is required, an inner control loop 18 will modulate the primary current to maintain the amplitude of the output waveform. An outer control loop 13 will keep only one of the pair of MOSFETs 7 and 8 switched on throughout a half cycle of the output waveform, to give the appropriate polarity of supply.

The secondary current flows in the path selected by a one of the MOSFETs 7 or 8. This charges an output capacitor 6 as appropriate to form the required output waveform. No circulating currents occur during large current demands and high efficiency, reduced power dissipation and reduced noise result.

When little or no ringer current is required, the secondary MOSFETs 7 and 8 change from operating as a polarity switch to operating as a high frequency modulator. This is necessary as, without a load current present, the voltage on the output capacitor 6 has no way of discharging during the second half of each half cycle to maintain the sinusoidal output waveform. Circulating currents during these light load conditions are not significantly wasteful.

While the present invention is described with reference to a flyback converter, alternative topologies can be used.

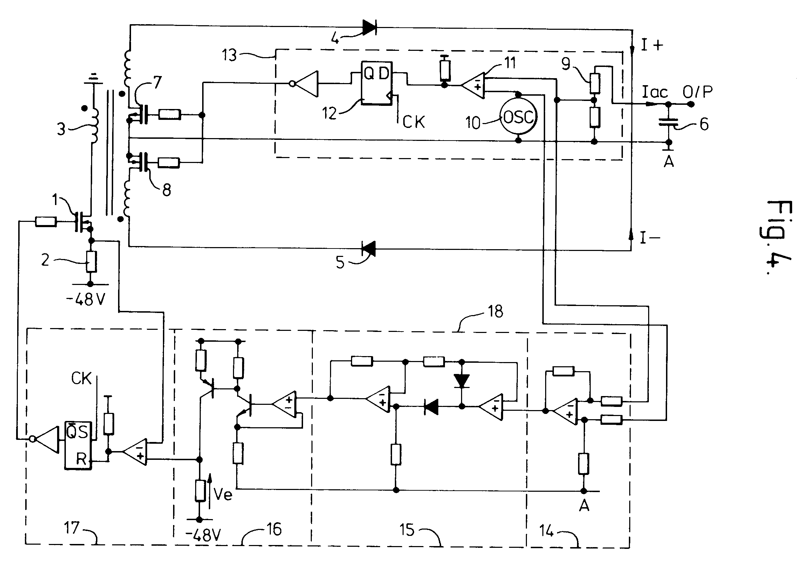

Referring to Figure 4, it can be seen that the outer control loop 13 contains a potential divider 9, which monitors the output voltage level on the capacitor 6. A reference sinewave oscillator 10 and the mid point of the divider 9 are applied to a differential amplifier 11 acting as a comparator. This will produce an output error voltage indicating the difference between the two inputs. This output is then synchronized with a clock by a flip-flop 12. This gives a minimum duration of 5 microseconds in any one state, any longer durations are multiples of this basic period.

The resulting output of the outer control loop 13 is applied as a switching voltage to the gates of a pair of MOSFETs 7 and 8. These are configured so that when one is switched on, the other will be switched off. These MOSFETs provide a path so that the output capacitor 6 can be charged to an appropriate polarity. MOSFET 7 allows positive charging via a diode 4, and MOSFET 8 allows negative charging via a diode 5. The necessary charging current is provided by a fly back transformer 3, whose secondary windings are connected into the appropriate paths. It should be noted that the secondaries inductances and the output capacitor 6, form a low pass filter so that a smooth output voltage waveform results.

When little or no ringer current Iac is required, the voltage on the output capacitor 6 has no external discharge path to maintain a sinusoidal output waveform. The control loop 13 will vary its duty cycle to maintain the correct voltage on the capacitor 6. The inputs to the comparator 11 are easily maintained in balance and therefore idling occurs. This is where charge is supplied to and removed from capacitor 6 many times during a half cycle of the output waveform and circulating currents occur.

The inputs to the differential amplifier 11 are also applied to an inner control loop 18. This contains a differential amplifier 14, which amplifies the difference between the sinewave reference oscillator 10 and the mid point of the divider 9. The output of the amplifier 14 is then applied to a full wave rectifier 15 which produces a unipolar error voltage. A voltage controlled current source 16 is then used to provide level shifting to apply an error voltage Ve to a pulse width modulator 17.

The pulse width modulator 17 turns on a primary MOSFET 1, current then builds up in the primary of the flyback transformer 3. This current is sensed by a resistor 2 and is used to reset the modulator 17 to provide current mode control. The magnitude of the error voltage Ve gives a corresponding pulse width from the modulator 17 and hence defines the peak primary current. This primary current is then transformed to the secondary windings by the flyback action of the transformer 3.

As the demand for ringer current Iac increases, then a higher primary current is required. This increase is supplied by an increase in the error voltage Ve applied to the pulse width modulator 17 and hence the overall difference between the input signals applied to the inner control loop 18. As these signals are also applied to comparator 11 in the outer control loop 13, an increasingly larger offset will appear between the inputs of comparator 11. This will keep the comparator 11 in one state, hence one of the pair of MOSFETs 7 and 8 will remain switched on for a complete half cycle of the output waveform. As the output goes through a zero transition the offset on comparator 11 changes polarity and causes the comparator to switch the opposite MOSFET on during the next half cycle.

In this mode of operation the output switching stage of MOSFET 7 and 8 is merely a polarity switch and the output amplitude is formed entirely by the inner control loop 18 modulating the primary. This gives good efficiency and hence low dissipation during large ringer current demands.

By the use of the flyback converter topology controlled by two voltage feedback loops, a circuit with two modes of operation dependent on the amount of load current required is produced. On large current demands only one high frequency switching stage is required to be in use to form the output voltage waveform, giving the circuit its high efficiency and corresponding small size.

## Claims

1. A ringer for a telephone system comprising a transformer characterised in that there is a first feedback loop controlling in use the primary current of the transformer in response to the ringer output and a second feedback loop controlling in use the secondary current of the transformer in response to the ringer output.

2. A ringer as claimed in Claim 1, further comprising respective differential amplifiers in the first and second feedback loops, and a potential divider connected across the ringer output and a reference oscillator, connected to respective inputs of each of the differential amplifiers.

3. A ringer as claimed in Claim 1 or 2, wherein the first feedback loop comprises a pulse width modulator connected to a switching transistor in series with a primary winding of the transformer.

4. A ringer as claimed in any preceding claim, wherein the second feedback loop has the output thereof connected to a switching transistor in series with a secondary winding of the transformer.

5. A ringer as claimed in any preceding claim, having a flyback topology.

Fig.1. PRIOR ART

Fig.2. PRIOR ART

# Fig.3.

# Fig.4.